# EUROPEAN PATENT APPLICATION

(11) **EP 1 768 168 A2**
(43) Date of publication of application: **28.03.2007**
(21) Application number: 06254923.3
(22) Date of filing: 22.09.2006
(51) Int. Cl.: H01L 21/00

(54) **Method of resin seal moulding electronic component and apparatus therefor**

(30) Priority: 27.09.2005 JP 2005280293
(71) Applicant: Towa Corporation, Kyoto 6018105 (JP)
(72) Inventor: Maeda, Keiji c/oTowa Corporation, Kyoto-shi Kyoto 601-8105 (JP)
(74) Representative: Roberts, David Leslie

(57) **Abstract**

A mold (110) for resin-seal-molding an electronic component is constituted by a first mold (111) and a second mold (112). A molding face (PL) of the molds has a substrate supply-set surface (113), which has a flat shape without a step. A pot block (140) is joined with and separated from a side position (110a) of the mold (110) perpendicular to the mold face (PL). In a state where the mold face and the pot block (140) are joined, a molten resin material in the pot block (140) is injected into a cavity (114). Further, a mold-opening is performed where the second mold (112) is separated away from the one mold (111) in a state where the resin-seal-molded substrate is fixed to a mold surface of the one mold (111). According to the present method, the overall structure of the mold (110) for resin-seal-molding an electronic component can be simplified.

## Description

This nonprovisional application is based on Japanese Patent Application No. 2005-280293 filed with the Japan Patent Office on September 27, 2005, the entire contents of which are hereby incorporated by reference.

### BACKGROUND OF THE INVENTION

### Field of the Invention

The present invention relates to a method of seal-molding an electronic component of a relatively small size such as a semiconductor chip by a resin material, and to an apparatus for resin-seal-molding an electronic component used for implementing the method.

### Description of the Background Art

Recently, an improvement has particularly been required in the function of a semiconductor package wherein an electronic component of a relatively small size such as a semiconductor chip is seal-molded by a resin material (hereinafter simply referred to as a semiconductor package). Specifically, for example a so-called MAP type large substrate has strongly been required to have higher integration, higher reliability, and further compactness; that is, to be lighter, thinner, shorter, and smaller.

Accordingly, when molding a semiconductor package, it is necessary to perform resin-seal-molding so that the structure thereof becomes compact as much as possible, in a state where the quality of the highly integrated component to be resin-seal-molded is maintained.

In such resin-seal-molding, in order to maintain the quality of the semiconductor package that is the component to be resin-seal-molded, it is important to improve adhesion (or contact) between the resin material for sealing the electronic component and the lead frame or substrate to which the electronic component is mounted (hereinafter simply referred to as a substrate). However, this also causes adhesion between the resin material and a surface of a mold for resin molding to be increased. Therefore, there is a problem that mold release characteristics in removing the molded product from the mold after the resin-seal-molding are deteriorated and the molded product cannot be released efficiently.

Additionally, for example if molded product releasing means for releasing the molded product by forcibly ejecting the molded product with an ejector pin or the like is employed, coupled with the compactness of the molded product, there is a problem that the molded product body (resin-seal-molded body) may be damaged and a crack may occur, or it may be broken and its quality may be degraded.

Further, when an ejector pin mechanism such as described above is incorporated into a resin-molding mold, there is a problem that the mold structure becomes complicated and the overall durability is impaired.

Still further, when a mechanism for melting the resin material or a mechanism for transferring the molten resin material is incorporated inside a mold, not only the mold structure becomes complicated but also there is a problem that resin-seal-molding conditions become limited based on the complicated mold structure.

In the following, conventional means for resin-seal-molding an electronic component is described.

First, it is widely known to provide a prescribed surface treatment on a mold cavity surface and the like in order to improve mold release characteristics in removing the molded product from the mold. However, the effect of the surface treatment is not uniform, and it is less durable. Further, in resin-seal-molding an electronic component, a thermosetting resin material such as epoxy resin is mainly used, and additionally, a large substrate is used. Under these circumstances, practically, the conventional ejector pin mechanism has been employed in combination, for surely and efficiently releasing the molded product.

Commonly, a conventional mold surface is provided with a recess (a clearance of a prescribed depth provided to a parting line (PL) face of a mold, as corresponding to the thickness of a substrate) for insert-setting a substrate. This recess invites the following problems.

The thickness of each site of a large substrate is not uniform, i.e., the thickness varies among each site. Additionally, it is common to simultaneously insert-set a large number of such large substrates to a mold surface. Therefore, clamping state is not uniform among the large substrates even if the large substrates are simultaneously applied with mold-clamping pressure. This sometimes causes part of the resin material to flow into between each of the large substrates and the mold surfaces, resulting in formation of resin flash on the substrate surface and on the mold surface. Conversely, if each of the substrates is applied with the clamping pressure so as to prevent the resin flash formation, there is an adverse effect that semiconductor elements or interconnections on the substrates are damaged if the clamping pressure is excessive.

Thus, the variation in the thicknesses of substrates has been a factor of significant degradation in the quality of molded products.

In a conventional mold structure, normally, a pot (a portion for melting a resin material) is provided inside the mold. On the aforementioned mold face (parting line PL face) of the mold, a resin-molding cavity and a resin path for transferring the molten resin material constituted of a cull, a runner and the like for implementing communication between the cavity and the pot are formed as recesses. Thus, on the mold face, the portion for insert-setting the substrate, the pot portion, the resin path portion and the like are provided as recesses. Based on such a mold structure, the following problem on the resin-seal-molding arises.

In this type of resin-seal-molding, prevention of formation of resin flash on the surface of substrate is regarded as the most important matter. Therefore, for example for the purpose of efficient application of clamping pressure to the substrate, clamping is often set so that the clamping pressure is higher in the portion for insert-setting the substrate than in the pot portion and the resin path portion. In resin-seal-molding, the resin pressure on the molten resin material acts to open the mold face of the mold. Accordingly, the molten resin material in the pot or in the resin path in the state described above is prone to enter a gap on the mold face than the space in other sites because of the resin pressure.

As a result, such an adverse effect arises that a thin resin flash is formed on the mold face near the pot portion and the resin path portion. Setting of resin-seal-molding conditions, setting of the mold surface shape or manufacturing of the mold for preventing such an adverse effect is extremely cumbersome. In addition, considering for example setting of resin-seal-molding conditions specific to the resin material used in the resin-seal-molding, there is a problem that the overall working efficiency is significantly impaired. Further, such a thin resin flash is difficult to be completely removed in the cleaning step. Thus, there is a problem that it mixes into the molten resin material in the next resin-seal-molding, resulting in a defective product. There is also a problem that the cured resin flash causes failure in clamping in the clamping step.

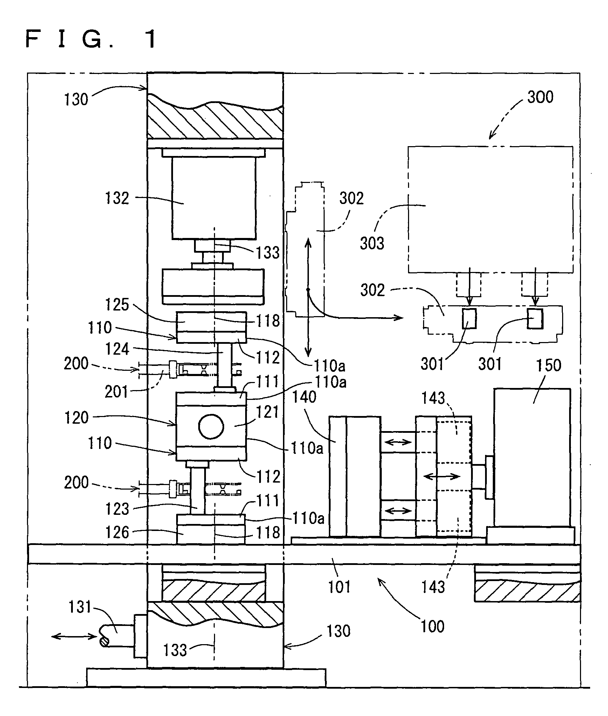

For solving the aforementioned problem of variation in the thicknesses of substrates, there is a proposal of a resin-seal-molding apparatus employing a so-called floating structure, wherein a substrate supporting member (pressing member) is supported by an elastic member in a recess (sliding hole) for insert-setting substrates (sheet-like member) (for example, see Japanese Patent Laying-Open No. 11-126787 (page 7, Fig. 1)).

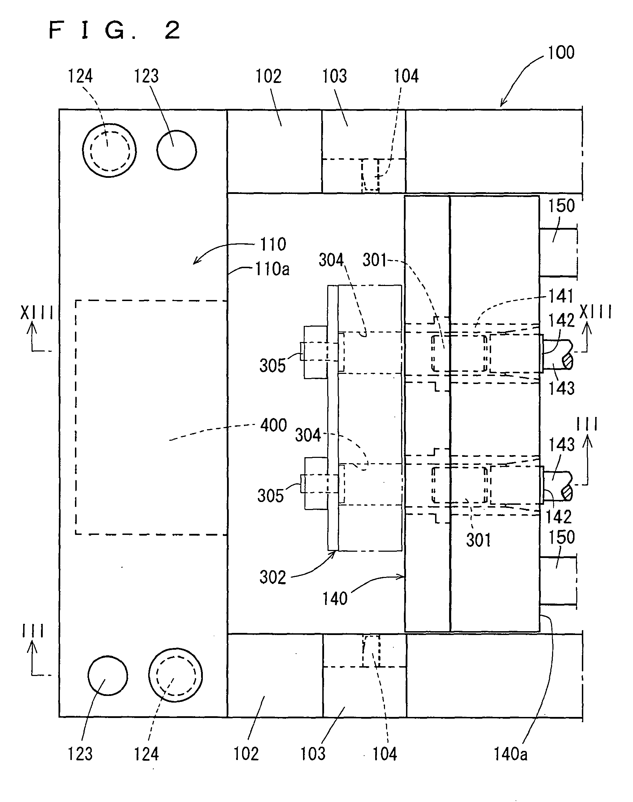

There is also a proposal of a resin-seal-molding apparatus having a configuration wherein the aforementioned mechanism for melting the resin material (injection cylinder), the mechanism for transferring molten resin material (press piston) and the like are arranged external to the mold (for example, see Japanese Patent Laying-Open No. 59-052842 (page 5, Fig. 2) 2). According to this configuration, there is an advantage of simplifying the mold structure by arranging the mechanism for melting the resin externally to the mold.

Among the conventional resin-seal apparatuses wherein many substrates are mounted on one mold structure to perform resin-seal-molding, the apparatus employing the floating structure for solving the aforementioned problem of variation in thickness of substrates (Japanese Patent Laying-Open No. 11-126787 (page 7, Fig. 1)) not only introduces further complication into a general mold structure, but also involves a problem of cumbersome mold manufacturing associated with an increase in costs. The following problem has also been pointed out. Works of adjusting elastic pressing force on each site of the substrate, works of adjusting elastic pressing force when performing resin-seal-molding to other type of substrate having different thickness and the like are cumbersome. Additionally, when resin-seal-molding electronic components while many substrates are supply-set to the mold face (PL face), coupled with the fact that substrates vary in thicknesses, works such as adjusting the elastic pressing force on each substrate is substantially impossible. Further, works such as mold maintenance is very cumbersome. Accordingly, it is difficult to bring the resin-seal-molding apparatus having the floating structure into practical use.

In the resin-seal-molding apparatus having a configuration wherein the aforementioned mechanism for melting the resin material, the mechanism for transferring molten resin material and the like are arranged externally to the mold (Japanese Patent Laying-Open No. 59-052842, (page 5, Fig. 2)), the mechanism for melting the resin material and the like are simply arranged externally to the mold. The structure such as a so-called cull portion, a resin path portion communicating with the cull portion, the gate portion and the like, which are generally employed as a mold structure, are arranged inside the mold. Thus, this site of the mold structure is the same as in the conventional mold structure. The basic mold structure is therefore not simplified. Further, the amount of resin cured in this site (the amount of resin to be wasted) is great and is not economical.

### SUMMARY OF THE INVENTION

An object of the present invention is to provide a method of resin-seal-molding an electronic component and an apparatus therefor, which can improve mold release characteristics of a molded product and a mold.

A method of resin-seal-molding an electronic component of the present invention includes: a before-resin-seal-molding substrate supplying step of supplying a before-resin-seal-molding substrate having an electronic component mounted thereon, between respective mold surfaces of one mold and the other mold provided to freely open and close; a clamping step of, when closing said mold surfaces to clamp, inserting the electronic component on the before-resin-seal-molding substrate and a prescribed surrounding portion into a molding cavity provided between said mold surfaces, and applying in this state a prescribed clamping pressure from the mold surface to a main surface of the substrate; a resin-seal-molding step of, after the clamping step, filling the cavity with a molten resin material to seal by the molten resin material the electronic component and the prescribed surrounding portion being inserted into the cavity, and to bring a resulting resin-seal-molded body and the substrate into close contact with each other to be integrated; and a resin-seal-molded substrate removing step of, after the resin-seal-molding step, opening the mold surfaces to remove the resin-seal-molded substrate. The mold surface of the one mold has a flat shape without a step for positioning the substrate, and the resin-seal-molding is performed in a state where the clamping pressure is constantly applied from the mold surface to a joining site of the mold surface of the one mold and the main surface of the substrate. In the resin-seal-molded substrate removing step, by performing mold-opening where the other mold is separated away from the one mold in a state where the resin-seal-molded substrate is fixed to at least the mold surface of the one mold, the resin-molded body closely contacting and integrated with the resin-seal-molded substrate is released from the other mold.

In the method of resin-seal-molding an electronic component of the present invention, desirably, fixing of the resin-seal-molded substrate in the resin-seal-molded substrate removing step is attained by suctioning the resin-seal-molded substrate relative to the mold surface of the one mold using decompression effect.

In the method of resin-seal-molding an electronic component of the present invention, desirably, fixing of the resin-seal-molded substrate to the one mold in the mold-opening where the other mold is separated away from the one mold is assisted by an undercut molding portion provided to the one mold.

In the method of resin-seal-molding an electronic component of the present invention, desirably, fixing of the resin-seal-molded substrate in the resin-seal-molded substrate removing step is attained by suctioning the resin-seal-molded substrate relative to the mold surface of the one mold using decompression effect, and further, fixing of the resin-seal-molded substrate to the one mold in the mold-opening where the other mold is separated away from the one mold is assisted by an undercut molding portion provided to the one mold.

In the method of resin-seal-molding an electronic component of the present invention, desirably, in the before-resin-seal-molding substrate supplying step, single before-resin-seal-molding substrate is supplied between the mold surfaces.

In the method of resin-seal-molding an electronic component of the present invention, desirably, in the before-resin-seal-molding substrate supplying step, an end face of the before-resin-seal-molding substrate and side position of the molds are positioned on an identical plane.

In the method of resin-seal-molding an electronic component of the present invention, desirably, a plurality of units of mold structure units, each supplied with the single before-resin-seal-molding substrate between respective mold surfaces, are arranged as stacked, and the clamping pressure is simultaneously applied to each of the mold structure units arranged as stacked.

An apparatus for resin-seal-molding an electronic component includes each means for implementing the method of resin-seal-molding an electronic component according to the aforementioned invention.

Employing the method of resin-seal-molding an electronic component according to the present invention, it is not necessary to use an apparatus for resin-seal-molding an electronic component with a complicatedly structured mold such as a conventional apparatus. Therefore, the operability or workability of an apparatus can be improved. As a result, practical application of the apparatus is facilitated.

According to the present invention, resin flash formation on the substrate surface can efficiently and surely be prevented without being affected by the variation in the thicknesses of substrates. Further, by performing mold-opening where the other mold is separated away from the one mold in a state where the resin-seal-molded substrate is fixed to the one mold surface, the resin-seal-molded substrate can be released more efficiently. Thus, a resin-seal-molded product of an electronic component of high quality and high reliability can be molded.

As a simple structure can be employed for the resin-seal-molding apparatus of the present invention, the shape of the overall apparatus can be made small, and the maintenance works of the mold can be carried out easily. Further, the waste resin amount can be suppressed to thereby contribute to resource saving.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a partially cutaway vertical cross-sectional front view showing the overview of a resin-seal-molding apparatus for implementing a method of resin-seal-molding an electronic component according to the present invention.
Fig. 2 is a partially cutaway plan view schematically showing substantial part of a resin-seal-molding portion in the resin-seal-molding apparatus in Fig. 1.
Fig. 3 is a partially cutaway vertical cross-sectional front view of the resin-seal-molding portion corresponding to Fig. 2, being a cross-sectional view along line III-III in Fig. 2, showing a mold-open state thereof, and a supply state of before-resin-seal-molding substrates and a resin material.
Fig. 4 is a partially cutaway vertical cross-sectional front view of the resin-seal-molding portion corresponding to Fig. 3, showing a clamping state thereof and a state in which the resin material is supplied inside a pot.
Figs. 5-7 are explanatory views showing one example of supply-setting before-resin-seal-molding substrate to a prescribed position on a mold surface.
Figs. 8-10 are explanatory views showing another example of supply-setting the before-resin-seal-molding substrate to a prescribed position on a mold surface.
Fig. 11 is a partially cutaway vertical cross-sectional front view of the resin-seal-molding portion corresponding to Fig. 4, showing a state of pressurizing and transferring the resin material in the pot into a mold cavity.
Fig. 12 is a partially cutaway plan view of the resin-seal-molding portion corresponding to Fig. 11, showing a state where a pot block is joined with the side position of the mold.
Fig. 13 is a partially cutaway vertical cross-sectional front view of the resin-seal-molding portion corresponding to Fig. 11, being a cross-sectional view along line XIII-XIII in Fig. 2.
Fig. 14 is a partially cutaway vertical cross-sectional front view of the resin-seal-molding portion corresponding to Fig. 3, showing a state of removing the resin-seal-molded substrate.
Figs. 15-17 show a resin-seal-molding apparatus according to a second embodiment of the present invention, wherein Figs. 15 and 16 are partially cutaway horizontal plan view of a resin-seal-molding portion, and Fig. 17 is a partially cutaway front view showing a resin-seal-molded substrate.
Figs. 18 and 19 are partially cutaway horizontal plan views of a resin-seal-molding portion of a resin-seal-molding apparatus according to a third embodiment of the present invention.
Figs. 20-22 are partially cutaway vertical front views of a resin-seal-molding portion of a resin-seal-molding apparatus according to a fourth embodiment of the present invention.

### DESCRIPTION OF THE PREFERRED EMBODIMENTS

A method of resin-seal-molding an electronic component of the present embodiment includes: a before-resin-seal-molding substrate supplying step of supplying a before-resin-seal-molding substrate having an electronic component mounted thereon, between respective mold surfaces of one mold and the other mold provided to freely open and close; a clamping step of, when closing the mold surfaces to clamp, inserting the electronic component on the before-resin-seal-molding substrate and a prescribed surrounding portion into a molding cavity provided between the mold surfaces, and applying in this state a prescribed clamping pressure from the mold surface to a main surface of the substrate; a resin-seal-molding step of, after the clamping step, filling the cavity with a molten resin material to seal by the molten resin material the electronic component and the prescribed surrounding portion being inserted into the cavity, and to bring a resulting resin-seal-molded body and the substrate into close contact with each other to be integrated; and a resin-seal-molded substrate removing step of, after the resin-seal-molding step, opening the mold surfaces to remove the resin-seal-molded substrate. Further, the mold surface of the one mold has a flat shape without a step for positioning the substrate, and the clamping pressure is constantly applied from the mold surface to a joining site of the mold surface of the one mold and the main surface of the substrate. In the resin-seal-molded substrate removing step, by performing mold-opening where the other mold is separated away from the one mold in a state where the resin-seal-molded substrate is fixed to at least the mold surface of the one mold, the resin-molded body closely contacting and integrated with the resin-seal-molded substrate is released from the other mold.

In an apparatus for resin-seal-molding an electronic component of the present embodiment, an electronic component mounted on a substrate is inserted into a molding cavity provided for resin-seal-molding an electronic component, and mold surfaces are closed. Clamping pressure is applied form the mold to a main surface of the substrate. Further, in the clamping state, by filing the cavity with a molten resin material, the electronic component fitted into the cavity is sealed with the resin material. The mold surface of the one mold supply-setting the substrate has a flat shape without a step for positioning the substrate. Substrate fixing means for fixing the resin-seal-molded substrate is formed at the mold surface of one of the molds for resin-seal molding. Thus, it includes each means capable of implementing the aforementioned method of resin-seal-molding an electronic component.

Therefore, according to such an apparatus for resin-seal-molding an electronic component of the present embodiment, the clamping pressure can be applied uniformly to the substrate supplied to the mold surface. Further, since the mold surface is not provided with a step for positioning the substrate and the like, for example it is not necessary to consider, as in the conventional manner, the relationship between the thickness of the substrate and a recess for fit-setting the substrate. That is, even when the substrates supplied to the mold surface vary in thicknesses, without being affected thereby, it becomes possible to apply clamping pressure to the substrate uniformly and efficiently. Further, by performing mold-opening where the other mold is separated away from the one mold, in a state where the resin-seal-molded substrate is fixed to the one mold surface, the resin-seal-molded substrate fixed to the one mold surface can be released easily and efficiently. As a result, an adverse effect such as damaging the substrate when it is released from the mold can be prevented.

Thus, formation of resin flash on the surface of a substrate can effectively and surely be prevented while damages to the substrate when it is released from the mold can be prevented, and therefore a resin-seal-molded product of an electronic component of high quality and high reliability can be formed.

It should be noted that, as described above, even with the substrates of the identical type, the substrates may vary in thicknesses. Without being affected by such variation in thicknesses of a substrates, it becomes possible to apply clamping pressure to the substrate uniformly and efficiently.

When performing resin-seal-molding of each of substrates of a different type, conventionally, it has been necessary to provide a recess for supply-setting or the like corresponding to the thickness of the substrate. Substrates of the different type vary in thicknesses, and thus involves the aforementioned problem. However, according to each method of the present embodiment, it becomes possible to apply clamping pressure uniformly and efficiently also to each of the substrates of a different type. Thus, as described above, the problem of variation in the thicknesses of substrates of one type can appropriately and easily be solved. Further, when there is a change in the resin-seal-molded product and therefore resin-seal-molding of substrates of a different type is to be carried out, variation in the thicknesses due to the change of the substrate themselves and variation in the thicknesses of the changed substrate can both appropriately and easily be addressed.

In the method of resin-seal-molding an electronic component of the present embodiment, fixing of the resin-seal-molded substrate in the resin-seal-molded substrate removing step is attained by suctioning the resin-seal-molded substrate relative to the one mold surface using decompression effect.

For the fixing of the substrate as described above, the apparatus for resin-seal-molding an electronic component of the present embodiment is provided with fixing means for providing suction of the resin-seal-molded substrate relative to the one mold surface using decompression effect. Thus, the apparatus of the present embodiment includes each means capable of implementing the method of resin-seal-molding the aforementioned electronic component.

Therefore, according to the method of the present embodiment, the resin-seal-molded substrate can be fixed to the one mold surface by suction force using decompression effect, and also mold-opening where the other mold is separated away from the one mold in this state can efficiently be conducted. By releasing the suction force using decompression effect, the resin-seal-molded substrate fixed to the one mold surface can be released easily and efficiently. As a result, an adverse effect such as damaging the resin-seal-molded substrate when releasing the substrate can be prevented, whereby a resin-seal-molded product of an electronic component of high quality and high reliability can be molded.

In the method of resin-seal-molding an electronic component of the present embodiment, the one mold is provided with an undercut molding portion, and fixing of the resin-seal-molded substrate to the one mold in the mold-opening where the other mold is separated away from the one mold is assisted by the undercut molding portion.

For the fixing of the substrate as described above, to the apparatus for resin-seal-molding an electronic component of the present embodiment, an undercut molding portion is formed at the one mold. Thus, the apparatus of the present embodiment includes each means capable of implementing the method of resin-seal-molding the aforementioned electronic component.

Therefore according to such an apparatus of the present embodiment, the resin-seal-molded substrate can be fixed to the one mold surface by the stopping force of the undercut portion simultaneously and integrally molded with the substrate in the resin-seal-molding step. Further, in this state, the mold-opening operation of separating the other mold away from the one mold can be conducted efficiently. By moving the resin-seal-molded substrate in a direction releasing the stopping force of the undercut portion, the resin-seal-molded substrate fixed to the one mold surface can be released easily and efficiently. As a result, when the resin-seal-molded substrate is released, an adverse effect such as damaging the substrate can be prevented, and therefore a resin-seal-molded product of an electronic component of high quality and high reliability can be molded.

In the method of resin-seal-molding an electronic component of the present embodiment, for fixing the resin-seal-molded substrate in the resin-seal-molded substrate removing step, suction means for suctioning the resin-seal-molded substrate relative to the one mold surface using decompression effect and the undercut molding portion for assisting fixing of the resin-seal-molded substrate to the one mold are both employed.

The apparatus for resin-seal-molding an electronic component of the present embodiment has suction means for suctioning the resin-seal-molded substrate relative to the one mold surface using decompression effect and an undercut molding portion formed at the one mold, for fixing to the substrate. Thus, it has each means capable of implementing the method of resin-seal-molding an electronic component of the present embodiment.

Thus, with such an apparatus, the function of fixing the resin-seal-molded substrate to the one mold surface by suction force using decompression effect and the function of fixing the resin-seal-molded substrate to the one mold surface by the stopping force of the undercut portion simultaneously and integrally molded with the substrate in the resin-seal-molding step can both be employed.

Accordingly, the resin-seal-molded substrate can more surely be fixed by the one mold surface by the suction force and the stopping force of the undercut portion, and by releasing the suction force and the stopping force of the under cut portion, the resin-seal-molded substrate fixed to the one mold surface can be released easily and efficiently. As a result, an adverse effect such as damaging the resin-seal-molded substrate when releasing the substrate can be prevented, whereby a resin-seal-molded product of an electronic component of high quality and high reliability can be molded.

In the method of resin-seal-molding an electronic component of the present embodiment, in the before-resin-seal-molding substrate supplying step, a single before-resin-seal-molding substrate is supplied between the mold surfaces.

In the apparatus for resin-seal-molding an electronic component of the present embodiment, a portion for supplying single substrate is provided to the mold face. Thus, the apparatus of the present embodiment includes each means capable of implementing the method of resin-seal-molding an electronic component of the present embodiment.

Therefore, according to such apparatus of the present embodiment, as compared to the aforementioned conventional apparatus wherein a plurality of before-resin-seal-molding substrates are simultaneously supply-set between the same mold surfaces, the overall shape of the mold and the resin-seal-molding apparatus employing it can be made smaller.

As described above, since substrates vary in thicknesses, when a plurality of substrates are simultaneously supply-set between mold surfaces of one mold structure unit and for example when each substrate is applied with clamping pressure in order to prevent resin flash formation on each substrate surface, an adverse effect of damaging semiconductor elements and interconnections on each substrate is invited if clamping pressure is excessive. Conversely, if the clamping pressure is not enough, an adverse effect of failing to uniformly and surely prevent resin flash formation on each substrate is invited.

However, even when substrates vary in thicknesses, the effect of the variation in thicknesses can be minimized if a single before-resin-seal-molding substrate is supplied between the mold surfaces, as compared to the case where a plurality of substrates are supplied between mold surfaces. Accordingly, selection and/or setting works of the clamping pressure to the before-resin-seal-molding substrate can be carried out easily.

In the method of resin-seal-molding an electronic component of the present embodiment, in the before-resin-seal-molding substrate supplying step, an end face of the before-resin-seal-molding substrate and side position of the mold are positioned on an identical plane.

The apparatus for resin-seal-molding an electronic component of the present embodiment is provided with a mechanism for supplying a before-resin-seal-molding substrate that positions an end face of the before-resin-seal-molding substrate and side position of the mold on an identical plane when supplying a before-resin-seal-molding substrate wherein an electronic component mounted on the substrate is inserted into the molding cavity. Thus, the apparatus of the present embodiment includes each means capable of implementing the method of resin-seal-molding an electronic component of the present embodiment.

Thus, according to such apparatus of the present embodiment, no gap is formed between the end face of the before-resin-seal-molding substrate and the side position of the mold, and therefore an adverse effect can be prevented, such as a molten resin material entering into the gap in the resin-seal-molding step and resulting in molding of cured resin in such a gap. Further, an adverse effect can efficiently and surely be prevented, such as part of the molten resin material in the gap flowing onto the bottom surface of the substrate and resulting in formation of a resin flash on a substrate surface.

In the method of resin-seal-molding an electronic component of the present embodiment, a plurality of units of mold structure units, each supplied with a single before-resin-seal-molding substrate between respective mold surfaces, are arranged as stacked, and the clamping pressure is simultaneously applied to each of the mold structure units arranged as stacked.

In the apparatus for resin-seal-molding an electronic component of the present embodiment, a plurality of units of mold structure units, each supplied with a single before-resin-seal-molding substrate between respective mold surfaces, are arranged as stacked, and the clamping pressure is simultaneously applied to each of the mold structure units arranged as stacked. Thus, the apparatus of the present embodiment includes each means capable of implementing the method of resin-seal-molding an electronic component of the present embodiment.

Therefore, according to such an apparatus of the present embodiment, the structure of the apparatus in the stack arrangement direction is increased in size corresponding to the size of the plurality of mold structure units to be arranged as stacked. It is noted that the clamping pressure applied to each of the plurality of substrates is substantially the same as that required for a single substrate.

Accordingly, there is no disadvantage such as necessity of increasing the size of the mold and apparatus corresponding to the number of substrate being supply-set, or necessity of high clamping pressure, as in the conventional mold structure wherein a plurality of before resin-seal-molding substrates are supply-set between mold surfaces of the identical mold structure unit. Since it is not necessary to set the clamping pressure to be gradually high corresponding to an increase in the number of the plurality of mold structure units, the overall shape of the mold and the resin-seal-molding apparatus can be made smaller as compared to the conventional mold structure. Further, since electronic components in each substrate can simultaneously be resin-seal-molded under the identical molding condition, uniform products of high quality and high reliability can be manufactured highly efficiently.

In the following, embodiments of the present invention will be described referring to the drawings.

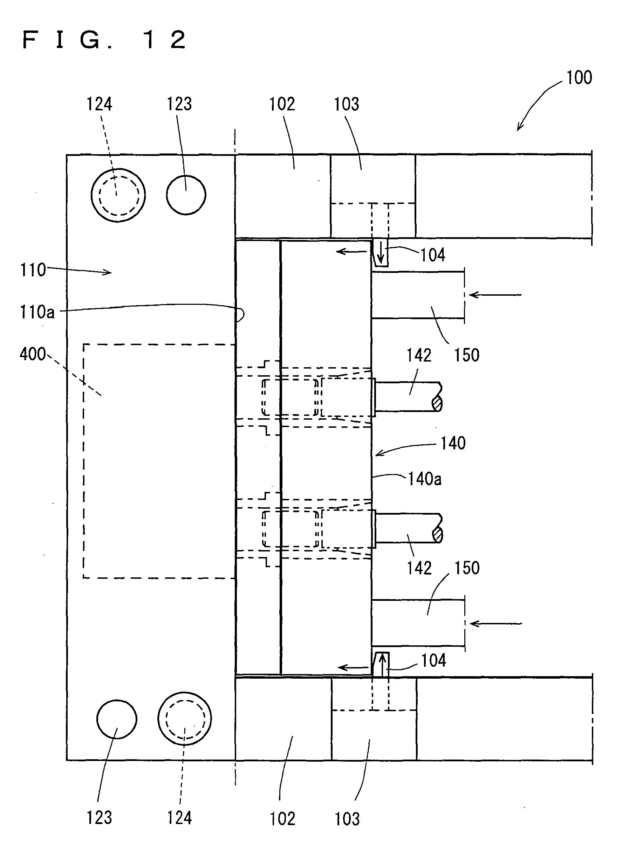

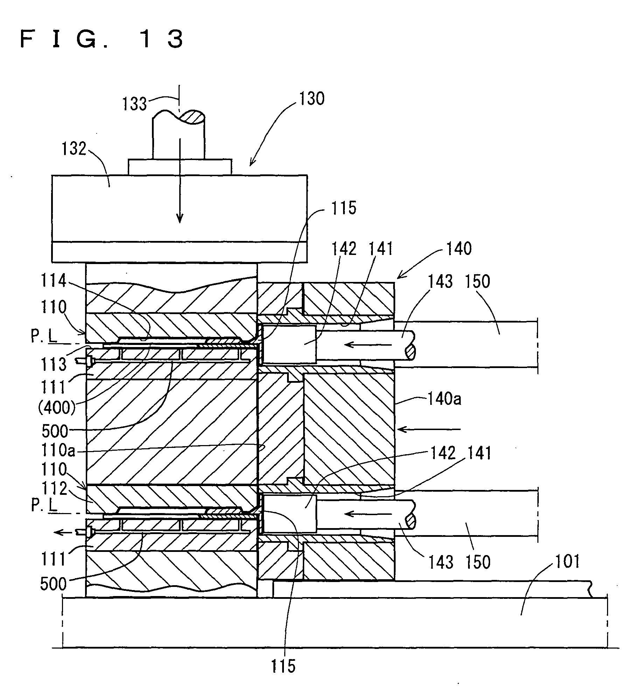

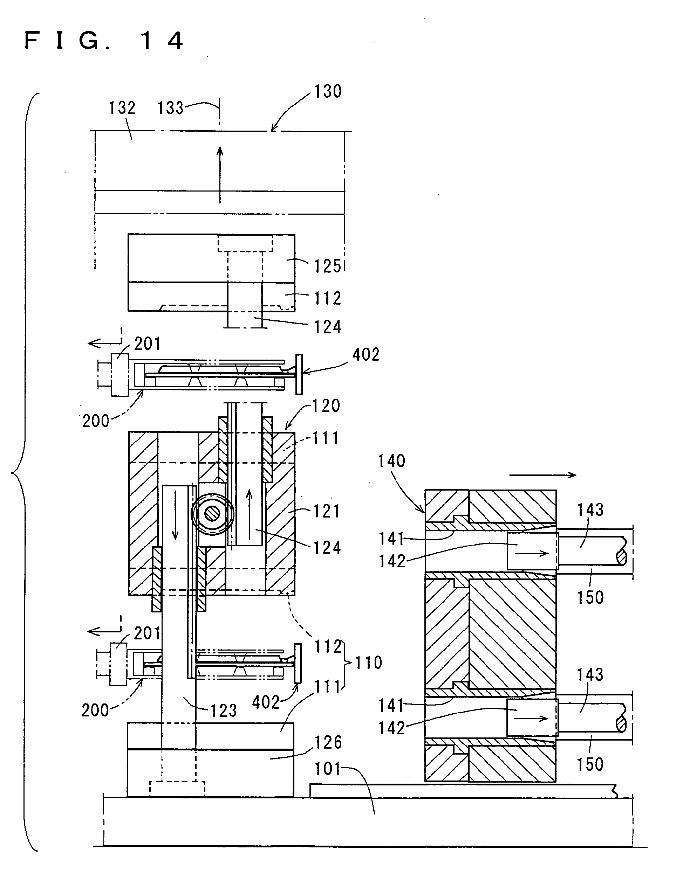

Figs. 1-14 show an apparatus for resin-seal-molding an electronic component of the first embodiment of the present invention. Fig. 1 schematically shows a configuration of a resin-seal-molding apparatus for implementing the resin-seal-molding method, and Figs. 2-14 schematically show substantial part of a resin-seal-molding portion in the resin-seal-molding apparatus.

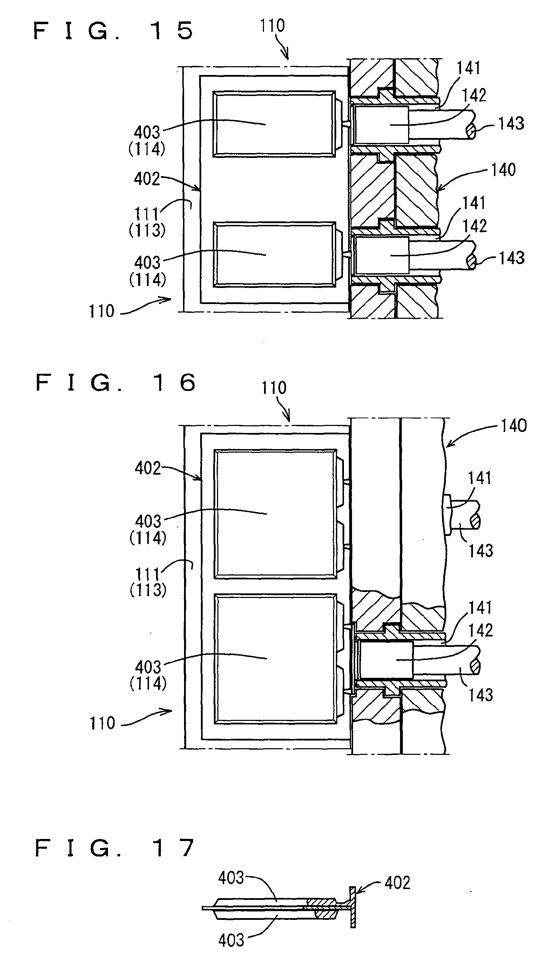

Figs. 15-22 show an apparatus for resin-seal-molding an electronic component of another embodiment of the present invention.

### First Embodiment

Fig. 1 schematically shows an overall configuration of a resin-seal-molding apparatus.

The resin-seal-molding apparatus includes a resin-seal-molding portion 100 for resin-seal-molding an electronic component on a substrate, a substrate supply-remove mechanism 200 for carry-supplying the before-resin-seal-molding substrate to a prescribed position, which will be described later, of the resin-seal-molding portion and for removing and carrying the resin-seal-molded substrate out of the resin-seal-molding portion, and a resin material carry-supply mechanism 300 for carry-supplying the resin material to a prescribed position, which will be described later, of the resin-seal-molding portion.

Resin-seal-molding portion 100 includes a mold 110 for resin-seal-molding an electronic component, a mold open-close mechanism 120 for opening and clamping the mold, a press frame mechanism 130 for applying prescribed clamping pressure to mold 110 in a state where mold 110 is clamped, a pot block 140 that is for supplying a resin material and that is arranged beside mold 110, and a mechanism 150 for reciprocate driving the pot block arranged so that pot block 140 is freely joined and separated with respect to side position 1 10a of the mold intersecting perpendicularly with mold face (PL face) of mold 110.

Mold 110 includes at least one set of mold structure unit. The drawing shows an example of a configuration in which two sets of mold structure units each constituted of a first mold 111 and a second mold 112 are arranged as stacked in the vertical direction.

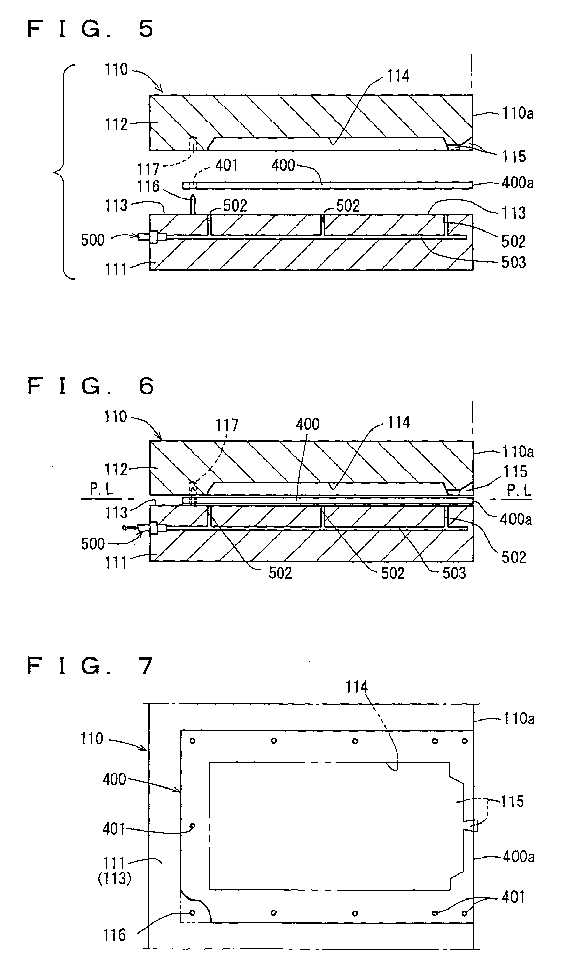

To the mold surface, that is, the mold face (PL face), of first mold 111, as shown in Figs. 5-7, a supply-set surface 113 for supplying substrate 400 is provided. Supply-set surface 113 implements a portion for supplying a single substrate for supply-setting one substrate 400 having an electronic component (not shown) mounted thereon. That is, to supply-set surface 113 for supplying and setting substrate 400 in the aforementioned one set of mold structure unit, only one substrate 400 is supplied and set. Further, to supply-set surface 113 for supplying substrate 400, a step or the like for positioning the substrate is not provided, which has been provided as a recessed shape in a conventional mold surface. Accordingly, supply-set surface 113 for supplying and setting substrate is formed in a flat shape. To the mold surface of second mold 112 arranged opposite to supply-set surface 113 of first mold 111, a resin-molding cavity 114 is provided.

Reference number 115 in Figs. 5-7 denotes a transfer path for a molten resin material. One end thereof is formed to communicate with cavity 114, while the other end thereof is formed to communicate with side position 1 10a of mold face (PL face).

Reference number 116 denotes a positioning pin provided at a prescribed position on the mold surface (substrate supply-set surface 113) of first mold 111. Similarly, reference number 117 denotes a pin hole formed at each position on second mold 112 opposite to each positioning pin 116. Positioning pin 116 and pin hole 117 show one example of means for supply-setting before-resin-seal-molding substrate 400 to a prescribed position on substrate supply-set surface 113.

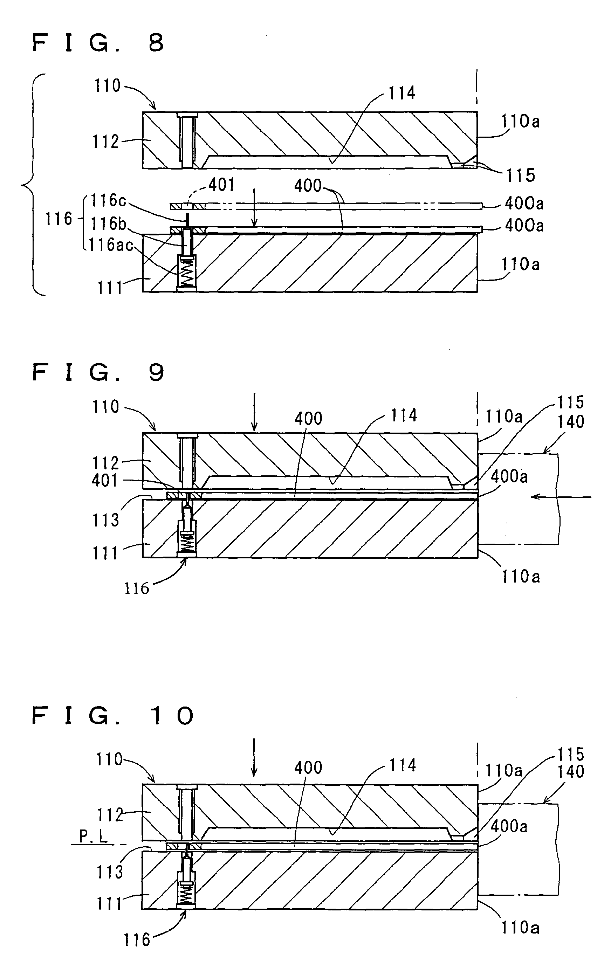

Specifically, when supply-setting substrate 400 to substrate supply-set surface 113, substrate 400 can efficiently and surely be supplied to a prescribed position on substrate supply-set surface 113 if a positioning hole 401 provided to substrate 400 and positioning pin 116 are engaged with each other. Further, performing clamping where two molds (111, 112) are closed in this state, each positioning pin 116 of first mold 111 is fitted into each pin hole 117 of second mold 112. Thus, as shown in Fig. 6, substrate 400 is surely supply-set to substrate supply-set surface 113.

Figs. 8-10 show another example of means for supply-setting before-resin-seal-molding substrate 400 to a prescribed position on substrate supply-set surface 113.

Positioning pin 116 provided to substrate supply-set surface 113 is elastically supported by an elastic member 116a, and its tip (upper end) shaft portion 116b is provided so that it projects from substrate supply-set surface 113. Tip shaft portion 116b is formed to be mated with a positioning hole 401a of substrate 400. Further, a tip of tip shaft portion 116b is provided with an engagement shaft portion 116c for positioning, which is formed as a shaft portion narrower than tip shaft portion 116b.

When supply-setting substrate 400 to substrate supply-set surface 113, end portion 400a of substrate 400 mated with tip shaft portion 116b through positioning hole 401a projects externally from side position 110a of mold 110, as shown in Fig. 8. Further, when clamping first mold 111 and second mold 112, second mold 112 is lowered to a position not reaching full clamping position (see Fig. 9). Here, positioning pin 116 is pressed by the mold face (which is the bottom surface of second mold 112. The drawing shows an example where a pressing pin is inserted into a site engaged with engage shaft portion 116c of the positioning pin), until engage shaft portion 116c thereof is mated with positioning hole 401 a of the substrate. In this state, by causing pot block 140 to be joined with side position 110a of molds 110, end portion 400a of the substrate is pressed by pot block 140 (see Fig. 9). Here, positioning hole 401a of the substrate is mated with engage shaft portion 116c of the positioning pin. Accordingly, pot block 140 can press the entire substrate 440 to slide it over substrate supply-set surface 113 so as to move it smoothly to a prescribed position, that is, so that end portion 400a of substrate 400 is positioned on the identical plane as side position 100a of the mold. Thereafter, second mold 112 is lowered to the full clamping position (see Fig. 10) to achieve full clamping.

Thus, by pot block 140 pressing substrate end portion 400a, substrate end portion 400a and side position 110a of the mold are fully positioned on an identical plane.

Thus, according to such apparatus of the present embodiment, no gap is formed between the end face of the before-resin-seal-molding substrate and the side position of the mold, and therefore in the resin-seal-molding step such an adverse effect can be prevented that a molten resin material enters into the gap and results in molding of cured resin in such a gap. Further, such an adverse effect can efficiently and surely be prevented that part of the molten resin material in the gap flows onto the bottom surface of the substrate and results in formation of resin flash on the substrate surface.

At cavity 114 of second mold 112, transfer path 115 for the molten resin material is formed. If an air vent (not shown) communicating with cavity 114 is formed at a position opposite to transfer path 115 of cavity 114, when injecting the molten resin material into cavity 114 which will be described later, residual air in cavity 114 is positively evacuated to the outside through the air vent by the injection of the molten resin material.

Figs. 8-10 show the resin-seal-molding apparatus provided with the mechanism for supplying the before-resin-seal-molding substrate having positioning pin 116 including elastic member 116a, tip end shaft portion 116b, engage shaft portion 116c and the like. The resin-seal-molding apparatus may have means for fixing the substrate to one mold 111, in addition to the supplying mechanism, as will be described later.

One mold 111 is provided with substrate fixing means 500 for fixing resin-seal-molded substrate 400.

Fig. 5 shows substrate fixing means having suction means 501 for suctioning resin-seal-molded substrate 400 relative to the mold surface (substrate supply-set surface 113) of one mold 111 using decompression effect.

Suction means 501 has a prescribed number of suction holes 502 opened at substrate supply-set surface 113 to join with one main surface of resin-seal-molded substrate 400 that is supply-set to substrate supply-set surface 113, and a ventilation path 503 allowing communication between suction holes 502 and a decompression pump (not shown).

Accordingly, with this configuration, operating the decompression pump to reduce the pressure in ventilation path 503 and suction hole 502, as shown in Fig. 6, resin-seal-molded substrate 400 supplied between first mold 111 and second mold 112 can be supply-set to substrate supply-set surface 113, and resin-seal-molded substrate 400 can be fixed in a state closely contacting to substrate supply-set surface 113 by suction force using the decompression effect. By releasing the suction force using the decompression effect, the resin-seal-molded substrate fixed to substrate supply-set surface 113 can be released easily and efficiently.

Mold open-close mechanism 120 is a mechanism for simultaneous mold-opening or clamping of the two sets of mold structure units (molds 110) arranged as stacked (overlaid) in the vertical direction. The drawing shows an example where a rack-pinion mechanism is included.

Body 121 of the mold open-close mechanism is provided with a pinion gear 122 rotated by a normal/reverse rotation drive motor (not shown), and two rack gears (123, 124) meshing with pinion gear 122 and moving reversely to each other in the vertical direction based on the normal and reverse rotation of pinion gear 122.

One rack gear 123 has its lower end portion fixed to a machine frame 101 fixed at a lower position, and has its upper end portion meshed with pinion gear 122. On the other hand, the other rack gear 124 has its lower end portion meshed with pinion gear 122, and has its upper end portion fixed to a mold mounting block 125 arranged above.

One set of mold structure unit (mold 110) constituted of first mold 111 and second mold 112 is provided to each of the upper surface and the lower surface of mold open-close mechanism body 121.

In the mold structure unit provided to the upper surface position of mold open-close mechanism body 121, first mold 111 thereof is fixed to the upper surface of mold open-close mechanism body 121, while second mold 112 is fixed to the lower surface of mold mounting block 125 arranged above. On the other hand, in the mold structure unit provided to the lower surface position of mold open-close mechanism body 121, second mold 112 thereof is fixed to the lower surface of mold open-close mechanism body 121, while first mold 111 is fixed to the upper surface of mold mounting block 126 provided to machine frame 101.

Therefore, according to such a configuration, by normally and reversely rotating pinion gear 122, simultaneous mold-opening and clamping of first mold 111 and second mold 112 in each of the two sets of mold structure units (molds 110) arranged as stacked in the vertical direction can be achieved.

Mold open-close mechanism 120 in the present embodiment is configured to simultaneously mold-open or clamp the two sets of mold structure units (molds 110) arranged as stacked in the vertical direction by rotating pinion gear 122 by a motor and moving rack gears (123, 124) meshed with pinion gear 122 reversely to each other in the vertical direction. However, the mold open-close mechanism is not limited to the aforementioned mold open-close mechanism, and other mechanism can be employed so long as it can simultaneously mold-open or clamp two sets of mold structure units (molds 110) arranged as stacked in the vertical direction. For example, as a drive source thereof, an appropriate fluid power mechanism, crank mechanism or other mechanic and electric vertical drive mechanism can be employed. Further, the drive source may move second mold 112 itself (or the rack gear) vertically, and the two sets of mold structure units (molds 110) arranged as stacked in the vertical direction can simultaneously be mold-opened or clamped in association therewith.

Press frame mechanism 130 is for applying prescribed clamping pressure to mold 110 in a state where mold 110 is clamped.

Press frame mechanism 130 is provided so that it can reciprocally move along machine frame 101 by an appropriate reciprocate drive mechanism 131. Press frame mechanism 130 is provided with press means 132 using electric, hydraulic, mechanic and other appropriate pressing mechanism.

Therefore, according to such a configuration, by reciprocate drive mechanism 131, such an alignment adjustment can be achieved that a press center position 133 of press means 312 in press frame mechanism 130 is moved to a position where it matches with a center position 118 of mold 110. Additionally, the pressing force of press means 132 can efficiently and surely be applied to center position 118 of clamped mold 110. Thus, in the mold clamping, the mold clamping pressure of the press means 132 applied to each of the mold structure units (molds 110) arranged as stacked is simultaneously and uniformly applied to each of the mold structure units.

It is noted that center position 118 of mold 110 refers to the center position of mold 110 itself. On the other hand, in the present embodiment, as described above, it is one feature that substrate end portion 400a and side position 1 10a of the mold are positioned on an identical plane. Accordingly, the center position of mold 110 in this case means the center position of the substrate at which clamping pressure can efficiently be applied to substrate 400. By reciprocate drive mechanism 131 moving press frame mechanism 130, the center position of substrate 400 and press center position 133 of press means 132 can be matched with each other.

While the present embodiment shows the mechanism where molds 110 are fixed to machine frame 101 so that press frame mechanism 130 reciprocates along machine frame 101, the relationship between them is relative. Accordingly, a configuration which is reverse of the configuration shown in the drawing, that is, the configuration where the position of press frame mechanism 130 is fixed and molds 110 reciprocate may be employed.

Further, while press means 132 and mold 110 (in the illustrated example, mold mounting block 125) are separated so as to implement the above-described relative movement, they (132, 125) may be fixed after the above-described center-alignment adjustment is finished. In this case, there is an advantage that, as the center-alignment adjustment is finished already, press means 132 can be used as a vertical drive mechanism for simultaneously mold-opening or clamping the two sets of mold structure units (molds 110) arranged as stacked, effectively using its movement in the vertical direction.

Pot block 140 is arranged beside mold 110, and provided so that it is freely joined and separated with respect to side position 110a of the mold intersecting perpendicularly with mold face (PL face) of mold 110 by reciprocate drive mechanism 150.

Pot block 140 is provided with a pot 141 that is for supplying a resin material and that is arranged corresponding to the number of the vertical two sets of mold structure units (molds 110) and their arrangement position, a plunger 142 for pressurizing the resin material supplied inside pot 141, and an appropriate reciprocate drive mechanism 143 for causing plunger 142 to reciprocate.

To a side frames 102 arranged each side portion of pot block 140, a stopper mechanism 103 is arranged for more surely maintaining joined state when pot block 140 is joined with side position 110a of the mold intersecting perpendicularly with mold face (PL face) of mold 110. Stopper mechanism 103 is provided with a stopper member 104 joining with a back surface 140a of pot block 140 joined with mold 110, so as to press and stop back surface 140a against side position 110a of mold 110.

Pot block 140 is provided with an appropriate heater (not shown) for heating and melting resin material 301 supplied inside pot 141.

Therefore, according to this configuration, by one reciprocate drive mechanism 150, the whole pot block 140 can be advanced to be joined with the end portion of the mold face of mold 110, and can be retracted to be separated from this position. Further, retracting plunger 142 by the other reciprocate mechanism 143, a space for supplying resin material 301 can be formed in opening-front-end of pot 141 (see Figs. 1-4). Advancing plunger 142 from this position, resin material 301 supplied into pot 141 can be pressed.

Communicating the space formed by first mold 111 and second mold 112 in the mold structure unit and pot 141 in pot block 140 with each other (see Figs. 8-12), and heating and melting resin material 301 in pot 141 by the heater and pressing resin material 301 with plunger 142, the molten resin material in pot 141 can directly be injected into cavity 14 through transfer path 115.

Substrate supply-remove mechanism 200 is provided so that, through a substrate supply-remove member 201 having an appropriate stop mechanism (not shown) such as a stop chuck, it can carry before-resin-seal-molding substrate 400 to a prescribed position in resin-seal-molding portion 100, that is, between first mold 111 and second mold 112 in each of the vertical two sets of mold structure units as mold-opened, and supply-set substrate 400 to substrate supply-set surface 113 of first mold 111. Further, substrate supply-remove mechanism 200 is provided so that it can stop resin-seal-molded substrate 402 (resin-seal-molded product) using the stop mechanism and remove it from substrate supply-set surface 113 as mold-opened after resin-seal-molding, and carry substrate 402 to the outside from between first mold 111 and second mold 112 in each of the vertical two sets of mold structure units and transfers it to an apparatus where the next process is performed.

Therefore, according to this configuration, before-resin-seal-molding substrate 400 can be supply-set to a prescribed position in resin-seal-molding portion 100 and resin-seal-molded substrate 402 can be removed to the outside of resin-seal-molding portion 100.

Resin material carry-supply mechanism 300 is provided so that it can supply resin material 301 accommodated in a resin material accommodating portion 303 to a prescribed position in resin-seal-molding portion 100 through a resin material carry-supply member 302, that is, to a space provided to the opening-front end of pot 141 when pot block 140 and plunger 142 are retracted to a prescribed position (see Figs. 1-4).

Resin material carry-supply member 302 is provided with holes 304 for feeding the resin material arranged corresponding to the number of the vertical two sets of mold structure units (molds 110) and their arrangement position, and extrude members 305 for extruding resin material 301 fed in holes 304 to supply it into pot 141.

Therefore, according to this configuration, resin material 301 can be supplied to each pot 141 in pot block 140 retracted to the prescribed position.

Resin-seal-molding of an electronic component in the above embodiment is carried out as follows, for example.

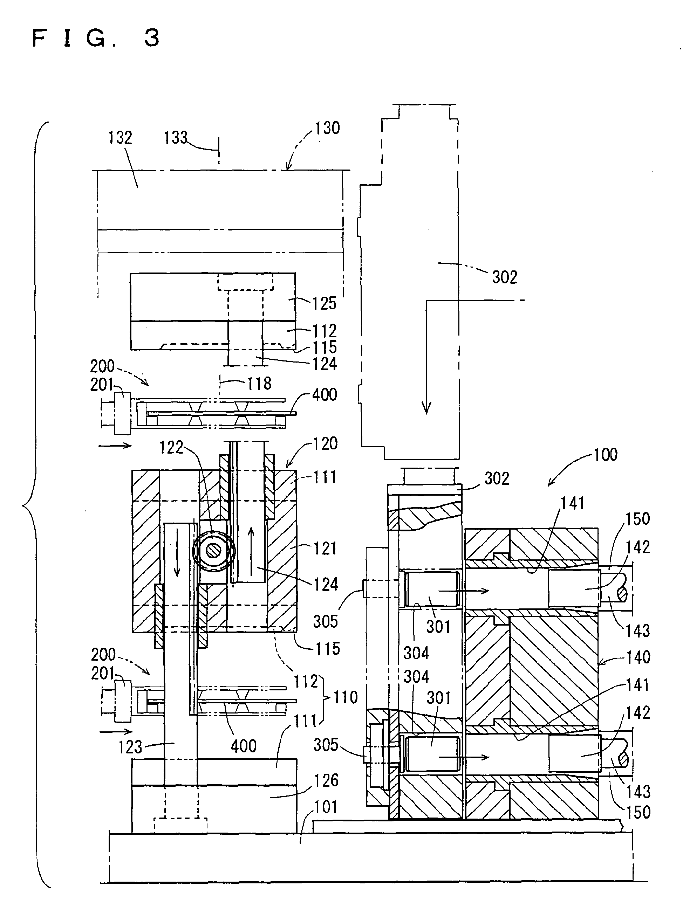

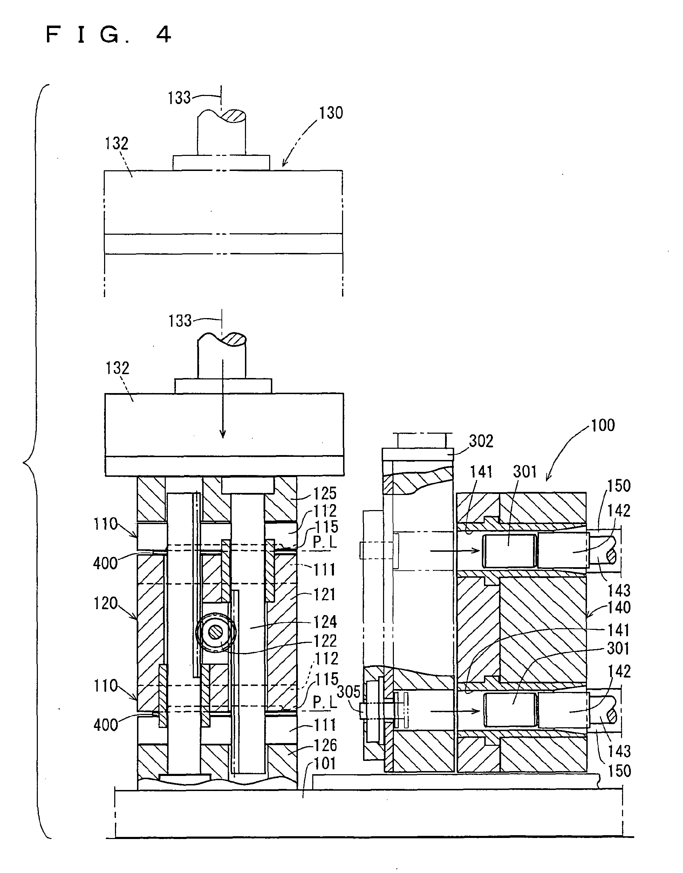

First, in the open-mold state of the vertical two sets of mold structure units (molds 110) shown in Figs. 1 and 3, substrate supply-remove mechanism 200 carries before-resin-seal-molding substrate 400 to between each first mold 111 and second mold 112, and supply-sets substrate 400 to substrate supply-set surface 113 of first mold 111. As shown in Fig. 4, reciprocate drive mechanism 150 retracts the entire pot block 140 from the position of mold 110, and reciprocate drive mechanism 143 retracts plunger 142 to form a space for supplying resin material 301 in the opening-front end of pot 141.

Next, as shown in Fig. 4, mold open-close mechanism 120 clamps the vertical two sets of mold structure units (molds 110).

Next, reciprocate drive mechanism 131 performs alignment adjustment of moving press center position 133 of press means 132 in press frame mechanism 130 to a position where it matches with center position 118 of mold 110 (see Fig.1), while press means 132 applies pressing force to center position 118 of clamped mold 110 to thereby apply clamping pressure of press means 132 to each of the mold structure units (molds 110) arranged as stacked simultaneously and uniformly (see Fig. 4). Resin material carry-supply member 302 supplies resin material 301 accommodated in resin material accommodating portion 303 into the space of pot 141 (see Figs. 1, 3 and 4).

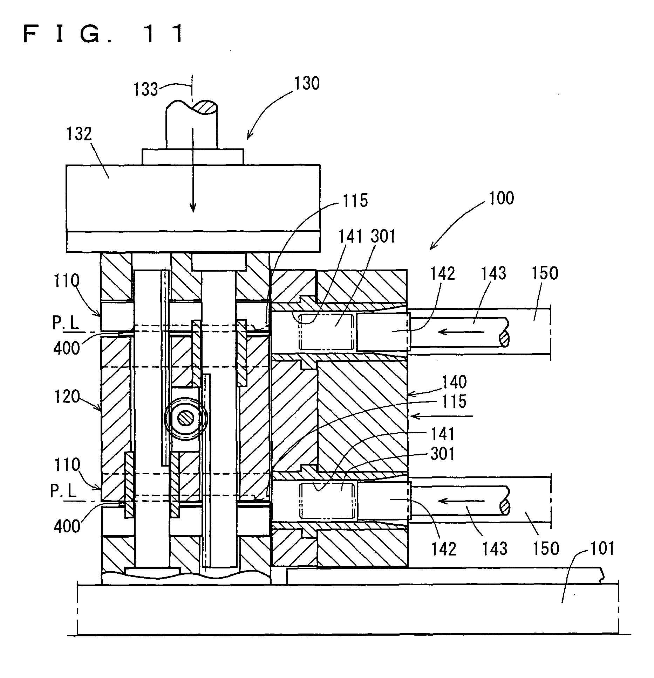

Next, as shown in Figs. 11-13, reciprocate drive mechanism 150 joins pot block 140 with side position 110a of the mold intersecting perpendicularly with mold face (PL face) of mold 110, and joins stopper member 104 in stopper mechanism 103 with back surface 140a of pot block 140, to press and stop back surface 140a against side position 110a of mold 110. Here, the space formed by first mold 111 and second mold 112 in the mold structure unit and pot 141 in pot block 140 communicate with each other, and resin material 301 supplied inside pot 141 is heated and melted by the heater.

Next, by advancing plunger 142 to press resin material 301 (molten resin material) in pot 141, the material is directly injected into cavity 114 through transfer path 115. Thus, the electronic component on substrate 400 fitted inside cavity 114 can be resin-seal-molded.

Next, after a prescribed cure time has elapsed, the stopped state of pot block back surface 140a by stopper member 104 is released, and as shown in Fig. 10, pot block 140 is moved by reciprocate drive mechanism 150 in a direction away from side position 110a of mold 110. Also, clamping to the vertical two sets of mold structure units (molds 110) by press means 132 of the press frame mechanism is released, and mold open-close mechanism 120 mold-opens the vertical two sets of mold structure units.

Next, the stop mechanism of substrate supply-remove mechanism 200 stops resin-seal-molded substrate 402 (resin-seal-molded product) and removes substrate 402 from substrate supply-set surface 113 as mold-opened, and carries substrate 402 to outside and transfers it to an apparatus where the next process is carried out.

As above, the apparatus for resin-seal-molding an electronic component shown in the present embodiment includes simply structured mold, and therefore the operability or workability thereof can be improved. This facilitates practical application of the apparatus.

Further, since resin flash formation on the substrate surface can efficiently and surely be prevented without being affected by the variation in the thicknesses of substrates, a resin-seal-molded product of an electronic component of high quality and high reliability can be molded. Still further, by performing mold-opening where the other mold is separated away from the one mold while the resin-seal-molded substrate is fixed to the one mold surface, the resin-seal-molded substrate having been fixed to the one mold surface can be released more efficiently.

As a simple structure can be employed for the resin-seal-molding apparatus, the shape of the overall apparatus can be made small, and the maintenance works of the mold can be carried out easily. Further, the wasted resin amount can be suppressed to thereby contribute to resource saving.

### Second Embodiment

Figs. 15-17 show a resin-seal-molding apparatus of another embodiment of the present invention, which is different from the resin-seal-molding apparatus of the first embodiment in the following points.

That is, while the resin-seal-molding apparatus of the first embodiment is provided with one resin-seal-region for resin-sealing an electronic component on one main surface of one substrate 400 (see Fig. 10), the resin-seal-molding apparatus of the present embodiment shown in Fig. 15 is provided with a plurality of resin-seal-regions (two in the illustrated example). Further, the apparatus of the present embodiment is different from the apparatus of the first embodiment in that it is provided with resin material supplying pots 141, resin material pressing plungers 142, and plunger reciprocate drive mechanisms 143 in the number corresponding to the aforementioned plurality of resin-seal-regions.

While the apparatus shown in Fig. 16 has basically the same structure as the apparatus shown in Fig. 15, it is different in that four resin-seal-regions are provided to one substrate, and that transfer path 115 for molten resin material is branched so that resin-seal-molding is performed simultaneously and efficiently in two of the resin-seal-regions.

Fig. 17 shows an example of a resin-seal-molded product 402 wherein electronic components mounted on both sides of one substrate 400 are simultaneously resin-seal-molded. Such molding of resin-seal-molded product 402 can be implemented if a cavity that is similar to resin-molding cavity 114 provided to the mold surface of second mold 112 in the first embodiment is provided to the mold surface of first mold 111 opposite to second mold 112.

While the apparatus of the second embodiment shown in Figs. 15 and 16 is different from the apparatus of the first embodiment as described above, the apparatus of the second embodiment achieves the function and effect similar to those described with reference to the first embodiment. In particular, the apparatus of the second embodiment is excellent over the apparatus of the first embodiment in that it can increase the number of resin-seal-molded products that can be obtained from one substrate (the number of resin-seal-molded products included in one substrate).

### Third Embodiment

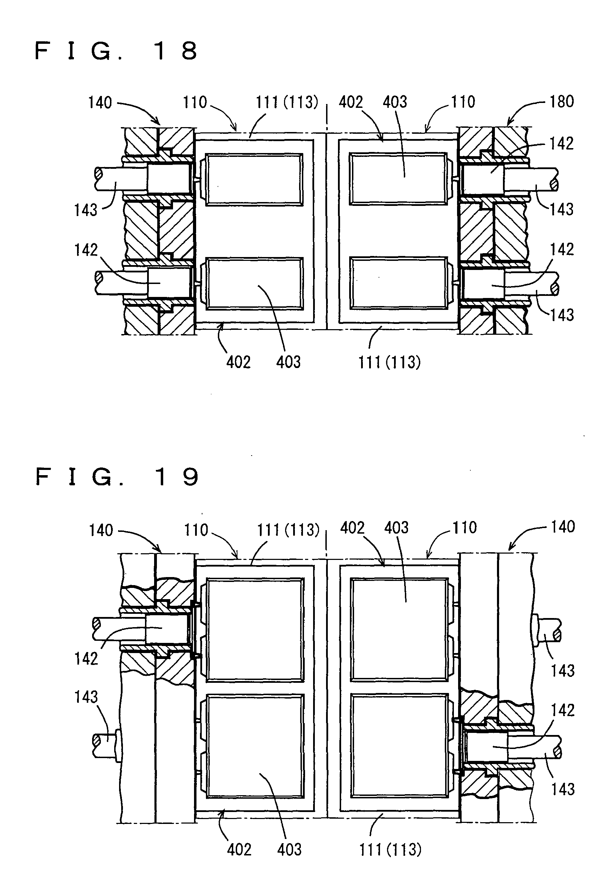

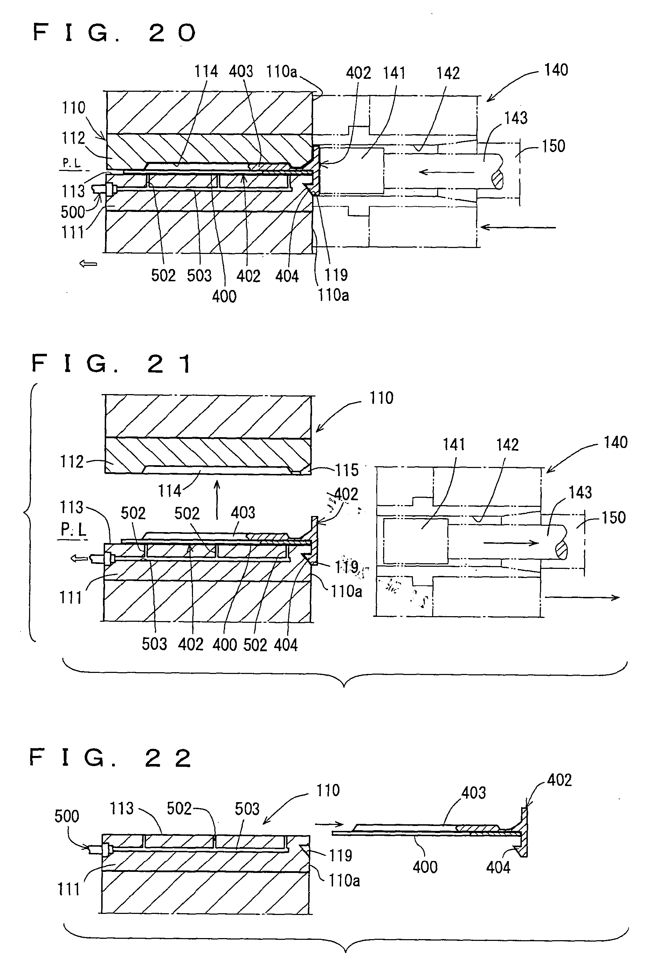

Figs. 18 and 19 show a resin-seal-molding apparatus of another embodiment of the present invention, which is a modification of the resin-seal-molding apparatus of the second embodiment shown in Figs. 15 and 16.

According to the apparatus of the second embodiment shown in Figs. 15 and 16, the number of resin-seal-molded products that can be obtained from one substrate can be increased. According to the apparatus of the third embodiment shown in Figs. 18 and 19, the number can further be increased.

In the apparatus shown in Fig. 18, the apparatus of the second embodiment shown in Fig. 15 is arranged on each side of right and left in the drawing symmetrically. In the apparatus shown in Fig. 19, the apparatus shown in Fig. 16 is arranged on each side of right and left in the drawing symmetrically.

In the apparatus of the third embodiment, the clamping pressure is individually applied to each of molds 110 arranged symmetrically. Accordingly, setting is made so that resin-molding conditions based on the thickness, shape and the like specific to one substrate do not affect resin-molding conditions of the other substrates.

With such an apparatus of the third embodiment, as the number of the resin-seal-molded products obtained from one substrate in one molding cycle can be increased, highly efficient production can be achieved.

### Fourth Embodiment

Figs. 20-22 show an apparatus of still another embodiment of the present invention, which is different from the apparatus of the first embodiment in the following points.

By providing an undercut molding portion 119 to first mold 111, in mold-opening where the other mold (second mold 112) is separated away from one mold 111, fixing of resin-seal-molded substrate 402 to first mold 111 is assisted.

In undercut molding portion 119, when molding resin-seal-molded body 403 by resin-sealing an electronic component inserted into cavity 114, an undercut portion 404 is simultaneously formed. Therefore, by the stopping force of undercut portion 404, resin-seal-molded substrate 402 can more surely be fixed to the mold surface of first mold 111, and in this state, as shown in Fig. 21, mold-opening where the other mold (second mold 112) is separated away from one mold 111 can efficiently be conducted.

As shown in Fig. 22, by moving resin-seal-molded substrate 402 in a direction releasing the stopping force by undercut portion 404 (in the right direction in the drawing), resin-seal-molded substrate 402 fixed to the mold surface of one mold 111 can be released easily and efficiently.

As a result, an adverse effect such as damaging resin-seal-molded substrate 402 when releasing the substrate can be prevented, whereby a resin-seal-molded product of an electronic component of high quality and high reliability can be molded.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of resin-seal-molding an electronic component, comprising:
a before-resin-seal-molding substrate supplying step of supplying a before-resin-seal-molding substrate (400) having an electronic component mounted thereon, between respective mold surfaces of one mold (111) and the other mold (112) provided to freely open and close;
a clamping step of, when closing said mold surfaces to clamp, inserting the electronic component on said before-resin-seal-molding substrate (400) and a prescribed surrounding portion into a molding cavity (114) provided between said mold surfaces, and applying in this state a prescribed clamping pressure from said mold surface to a main surface of said substrate (400);
a resin-seal-molding step of, after said clamping step, filling said cavity (114) with a molten resin material to seal by said molten resin material the electronic component and the prescribed surrounding portion being inserted into said cavity (114), and to bring a resulting resin-seal-molded body and said substrate (400) into close contact with each other to be integrated; and
a resin-seal-molded substrate removing step of, after said resin-seal-molding step, opening said mold surfaces to remove the resin-seal-molded substrate (400), wherein
the mold surface (113) of said one mold (111) has a flat shape without a step for positioning said substrate, and the resin-seal-molding is performed in a state where the clamping pressure is constantly applied from said mold surface to a joining site of the mold surface (113) of said one mold (111) and the main surface of said substrate (400), and
in said resin-seal-molded substrate removing step, by performing mold-opening where said other mold (112) is separated away from said one mold (111) in a state where said resin-seal-molded substrate is fixed to at least the mold surface (113) of said one mold (111), said resin-molded body closely contacting and integrated with said resin-seal-molded substrate (400) is released from said other mold (112).

2. The method of resin-seal-molding an electronic component according to claim 1, wherein
fixing of said resin-seal-molded substrate (400) in said resin-seal-molded substrate removing step is attained by suctioning said resin-seal-molded substrate (400) relative to the mold surface (113) of said one mold (111) using decompression effect.

3. The method of resin-seal-molding an electronic component according to claim 1, wherein
fixing of said resin-seal-molded substrate (400) in the mold-opening where said other mold is separated away from said one mold (111) is assisted by an undercut molding portion (119) provided to said one mold (111).

4. The method of resin-seal-molding an electronic component according to claim 1, wherein
fixing of said resin-seal-molded substrate (400) in said resin-seal-molded substrate removing step is attained by suctioning said resin-seal-molded substrate relative to the mold surface (113) of said one mold (111) using decompression effect, and further, fixing of said resin-seal-molded substrate (400) in the mold-opening is assisted by an undercut molding portion (119) provided to said one mold (111).

5. The method of resin-seal-molding an electronic component according to claim 1, wherein
in said before-resin-seal-molding substrate (400) supplying step, single said before-resin-seal-molding substrate (400) is supplied between said mold surfaces.

6. The method of resin-seal-molding an electronic component according to claim 1, wherein
in said before-resin-seal-molding substrate supplying step, an end face (400a) of said before-resin-seal-molding substrate (400) and side position (110a) of said one mold (111) and said other mold (112) are positioned on an identical plane.

7. The method of resin-seal-molding an electronic component according to claim 1, wherein
a plurality of units of mold structure units, each supplied with said single before-resin-seal-molding substrate (400) between respective mold surfaces, are arranged as stacked, and said clamping pressure is simultaneously applied to each of said mold structure units arranged as stacked.

8. An apparatus for resin-seal-molding an electronic component, comprising
each means for implementing the method of resin-seal-molding an electronic component according to claim 1.
